# EUROPÄISCHE PATENTSCHRIFT

(11) **EP 0 611 974 B1**
(45) Veröffentlichungstag und Bekanntmachung des Hinweises auf die Patenterteilung: **20.08.1997**
(21) Anmeldenummer: 94101500.0
(22) Anmeldetag: 02.02.1994
(51) Int. Cl.: G02B 6/255, G01R 15/24

(54) **Sensorkopf für eine faseroptische Strommessvorrichtung**
Sensor head for a fibre optic current measuring apparatus
Tête de sonde pour dispositif de mesure de courant à fibre optique

(30) Priorität: 17.02.1993 DE 4304762
(43) Veröffentlichungstag der Anmeldung: 24.08.1994
(73) Patentinhaber: ABB RESEARCH LTD., 8050 Zürich (CH)
(72) Erfinder: Meier, Markus, Dr., CH-5000 Aarau (CH)
(74) Vertreter: Kaiser, Helmut, Dr.

(56) Entgegenhaltungen:
- EP-A- 0 108 671
- EP-A- 0 148 012

## Beschreibung

### TECHNISCHES GEBIET

Bei der Erfindung wird ausgegangen von einem Sensorkopf für eine faseroptische Strommessvorrichtung nach dem einleitenden Teil von Patentanspruch 1.

### STAND DER TECHNIK

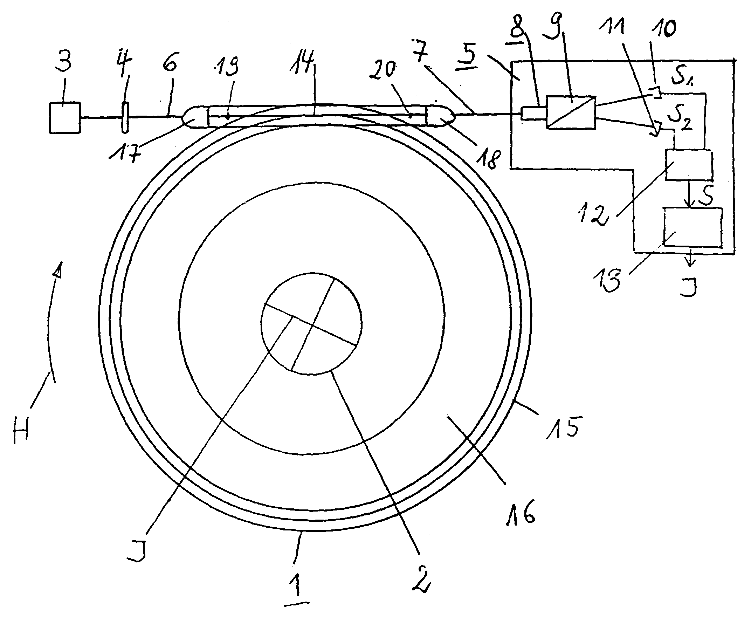

Die Erfindung nimmt dabei Bezug auf einen Stand der Technik, wie er sich beispielsweise aus der Veröffentlichung von K.Bohnert und R.Stierlin: Faseroptische Sensoren, Bulletin SEV/VSE 82(1991)1, S.21-29 ergibt. In Bild 6 beschreibt diese Veröffentlichung ein Prinzipschema eines faseroptischen Stromsensors mit polarimetrischer Detektion. Dieser Stromsensor weist einen einen stromführenden Leiter umfassenden Sensorkopf mit einer niedrigdoppelbrechenden Sensorfaser (LB-Faser) auf. Die LB-Faser ist als Spule um den Stromleiter gewunden. Von einer Lichtquelle wird der LB-Faser über eine polarisationserhaltende Faser (HB-Faser) linear polarisiertes Licht zugeleitet. In der LB-Faser führt das polarisierte Licht unter dem Einfluss des Magnetfeldes des Leiterstromes eine Faraday-Rotation aus. Das durch die Faraday-Rotation modifizierte und Informationen über die Höhe des Leiterstromes enthaltende polarisierte Licht wird über eine weitere (polarisationserhaltende) HB-Faser einer Detektions- und Auswertevorrichtung zugeleitet, in der der Wert des Leiterstromes ermittelt wird.

Die Genauigkeit eines solchen Sensors wird wesentlich durch Doppelbrechung bestimmt, die z.B. durch Biegen der LB-Faser beim Spulenwickeln induziert wird. Um den Einfluss dieser Doppelbrechung drastisch zu reduzieren, ist die LB-Faser zusätzlich noch mechanisch um die Faserachse verdrillt. Bedingt durch die hierbei auftretende Torsionsspannung tritt nun eine kontrollierbare zirkulare Doppelbrechung auf, welche je nach Verdrillungsgrad wesentlich grösser ist als die durch Biegespannungen beim Spulenwickeln induzierte, schwer erfassbare lineare Dopppelbrechung.

### KURZE DARSTELLUNG DER ERFINDUNG

Der Erfindung, wie sie in Patentanspruch 1 angegeben ist, liegt die Aufgabe zugrunde, einen Sensorkopf für eine faseroptische Strommessvorrichtung zu schaffen, welcher sich trotz einfachen und robusten Aufbaus durch hohe Messgenauigkeit auszeichnet.

Der Sensorkopf nach der Erfindung zeichnet sich durch einen einfachen und robusten Aufbau aus und liefert auch unter erschwerten Betriebsbedingungen sehr genaue Messwerte. Dies ist zum einen dadurch bedingt, dass seine optischen Aktivteile praktisch alle in Fasertechnik ausgeführt sind. Zum anderen ist dies aber auch eine Folge einer praktisch kräftefreien Anordnung der als Stromsensor wirkenden, niedrigbrechenden LB-Faser. Diese Faser ist nämlich mit polarisationserhaltenden HB-Fasern verspleisst und ist ausschliesslich über die HB-Fasern in der Nähe der Spleissstellen fixiert.

Das die Faraday-Rotation ausführende polarisierte Licht wird in äusserst einfacher und wirkungsvoller Weise in die als Faraday-Rotator wirkende LB-Faser eingekoppelt und zugleich werden durch Fixierung der gegen mechanische und thermische Belastungen unempfindlichen HB-Fasern unerwüschte, die Faraday-Rotation verfälschende mechanische Kräfte von der LB-Faser ferngehalten.

Ein bevorzugtes Ausführungsbeispiel der Erfindung und die damit erzielbaren weiteren Vorteile werden nachfolgend anhand einer Zeichnung näher erläutert.

### KURZE BESCHREIBUNG DER ZEICHNUNG

In dieser Zeichnung ist ein Ausführungsbeispiel der Erfindung vereinfacht dargestellt, und zwar zeigt die einzige Figur eine in Richtung eines Stromleiters geführte Aufsicht auf einen erfindungsgemässen Sensorkopf, welcher in einer grösstenteils lediglich als Prinzipschema dargestellten faseroptischen Strommessvorrichtung angeordnet ist.

### WEGE ZUR AUSFÜHRUNG DER ERFINDUNG

In der einzigen Figur bezeichnet 1 einen Sensorkopf einer faseroptischen Strommessvorrichtung. Durch den Sensorkopf 1 ist ein Stromleiter 2 geführt. Im Stromleiter 2 durch die Zeichnungsebene hindurchfliessender Strom J ruft ein in Richtung eines Pfeils gerichtetes magnetisches Feld H hervor. Die faseroptischen Strommessvorrichtung weist neben einem Sensorkopf 1 auch eine vorzugsweise als Laserdiode ausgebildete Lichtquelle 3, einen Polarisator 4 und eine Detektions- und Auswerteeinheit 5 auf. Ein nicht bezeichneter Lichtleiter führt das Licht der Lichtquelle 3 an den Polarisator 4, in dem linear polarisiertes Licht erzeugt wird. Das polarisierte Licht wird mittels einer polarisationserhaltenden, vorzugsweise aus Quarz bestehenden Faser 6, einer sogenannten HB-Faser, in den Sensorkopf 1 geführt, in dem das zugeführte Licht aufgrund des magnetischen Feldes H eine Faraday-Rotation ausführt. Aus dem Sensorkopf austretendes polarisiertes Licht wird mittels einer weiteren polarisationserhaltenden und vorzugsweise ebenfalls aus Quarz bestehenden Faser, der HB-Faser 7, in die Detektions- und Auswerteeinheit 5 geführt. HB-Fasern, wie die Fasern 6 und 7, weisen inhärent eine grosse Doppelbrechung auf und können mit grossen mechanischen Kräften beaufschlagt werden kann, ohne dass in einem weiten Temperaturbereich (-40°C - 80°C) ihre polarisationsoptischen Eigenschaften gestört werden. HB-Fasern weisen in Ausbreitungsrichtung des polarisierten Lichtes zudem zwei aufeinander orthogonal stehende Achsen auf, in denen die lineare Polarisation des Lichtes nicht beeinflusst wird.

Die Detektions- und Auswerteeinheit 5 enthält ein Polarimeter 8 mit z.B. einem Wollaston-Prisma 9 sowie zwei Photodetektoren 10, 11, eine Vorrichtung 12 zur Ermittlung eines die Faraday-Rotation und damit die Grösse des zu messenden Stromes im Sensorkopf 1 erfassenden Signals S und eine Vorrichtung 13 zur Bestimmung des Wertes des zu messenden Stromes J.

Der Sensorkopf 1 enthält als Stromsensor eine spulenförmig um den Stromleiter 2 gewickelte, niedrigdoppelbrechende und vorzugsweise ebenfalls aus Quarzglas bestehende Faser, eine sogenannte LB-Faser 14. Die LB-Faser 14 ist um ihre Faserachse verdrillt und ist in einer als Spule gewickelten und vorzugsweise ebenfalls aus Quarzglas bestehenden Kapillare 15 geführt. Die Kapillare 15 hat typischerweise einen Durchmesser von 0,2 bis 0,5 mm und ist auf einem starren Spulentragkörper 16 elastisch gelagert. Diese elastische Lagerung wird vorzugsweise dadurch erreicht, dass die Kapillare 15 in ein auf dem Spulentragkörper 16 aufliegendes Elastomer, beispielsweise Silikongummi, eingebettet ist. Die beiden polarisationserhaltenden HB-Fasern 6, 7 sind jeweils an entgegengesetzten Enden in die Kapillare 15 eingeführt und sind im Bereich der beiden Einführöffnung jeweils mittels einer Klebverbindung 17, 18 an der Kapillare 15 befestigt. Die Klebverbindungen 17, 18 sind vorzugsweise von einem Elastomer, wie insbesondere einem Silikon, gebildet.

Die Fasern 6 und 14 bzw, 14 und 7 sind an ihren einander zugewandten Enden miteinander dauerhaft und stabil verspleisst. Hierbei werden die Spleissstellen 19 und 20 durch Aufschmelzen gebildet. Die beiden Spleissstellen 19 und 20 im Inneren der Kapillare 15 sind zur Vermeidung von Fremdfeldempfindlichkeit möglichst nahe beieinander angeordnet. Die Klebeverbindungen 17 und 18 befinden sich in der Nähe der Spleissstellen.

Anstelle eines Lichtleiters und eines Polarisators 4 kann zwischen der Lichtquelle 3 und dem Eingang der HB-Faser 6 durch Aufschmelzen eine polarisiertes Licht erzeugende Faser eingespleisst werden. Der Sensorkopf der faseroptischen Strommessvorrichtung enthält dann im wesentlichen nur noch Faserelemente und kann entsprechend einfach und raumsparend ausgebildet sein.

Bei einer Messung des im Stromleiter 2 geführten Stromes J tritt linear polarisiertes Licht aus dem Polarisator 4 bzw. der anstelle des Polarisators 4 vorgesehenen Faser in die HB-Faser 6. Die HB-Faser 6 gewährleistet wegen ihrer polarisationserhaltenden Eigenschaften, dass das polarisierte Licht trotz der mechanische Spannungen in der Faser 6 erzeugenden Klebverbindung 17 ungestört in die LB-Faser 14 geleitet wird.

Die LB-Faser 14 ist praktisch kräftefrei an den beiden Spleissstellen 19 und 20 gehalten. Die durch ihre Verdrillung hervorgerufene Torsionsspannung wird über die beiden Spleissstellen 19 und 20, die beiden HB-Fasern 6, 7 und die beiden Klebverbindung 17, 18 auf die Kapillare 15 übertragen. Da die LB-Faser 14 aus einem Material besteht, das den gleichen Wärmeausdehnungskoeffizienten aufweist wie die Kapillare 15, rufen Temperaturänderungen keine Druck- oder Zugspannungen in der LB-Faser 14 hervor. Die polarisationsoptischen Eigenschaften der LB-Faser 14 bleiben praktisch unverändert. Dies ist von besonderem Vorteil, da eine LB-Faser normalerweise schon bei der Einwirkung geringer mechanischer Kräfte hinsichtlich ihrer polarisationsoptischen Eigenschaften empfindlich reagiert. Zudem werden durch unterschiedliche Materialausdehnungen zwischen dem Spulentragkörper 16 und der Kapillare 15 infolge Temperaturänderungen hervorgerufene mechanische Kräfte von der Kapillare 15 aufgenommen und von der LB-Faser 14 ferngehalten. Durch Einbetten der Kapillare 15 in ein Elastomer werden hierbei die bei Temperaturänderungen auftretenden Kräfte zwischen Spulentragkörper 16 und Kapillare 15 homogenisiert und unerwünschte Spannungsspitzen vermieden.

Die Polarisationsebene des die LB-Faser 14 durchlaufenden polarisierten Lichtes führt unter dem Einfluss des Magnetfeldes H des durch den Stromleiter 2 fliessenden Stromes J eine stromstärkeabhängige Faraday-Rotation aus. Die Verdrillung der LB-Faser 14 ist nun so ausgeführt, dass im stromlosen Zustand die Polarisationsrichtung des Lichtes an der Spleissstelle 20 unter 45° zu den beiden aufeinander orthogonal stehenden Achsen der HB-Faser 7 steht. An der Spleissstelle 20 findet somit eine Aufteilung des die Information über die Faraday-Rotation enthaltenden linear polarisierten Lichtes in zwei orthogonal aufeinanderstehende Komponenten statt. Die beiden Komponenten werden dem Polarimeter 8 zugeführt, im Wollaston-Prisma 9 voneinander getrennt und als Signale S₁ und S₂ in den beiden Photodetektoren 10 und 11 registriert. Durch die Faraday-Rotation der Polarisationsebene des Lichtes ändern sich die Intensitäten der beiden aufeinander orthogonal stehenden Komponenten und damit die Grössen der von den Photodetektoren 10 und 11 ausgegebenen Signale S₁ und S₂. Der temperaturabhängige Anteil der Lage der Polarisationsebene wird durch das Verhältnis der beiden Signale S₁ und S₂ erfasst und daraus die Temperatur des Sensorkopfs bestimmt. Aus den beiden Signalen S₁ und S₂ wird das Signal S ermittelt. Die Vorrichtung 13 schliesslich bestimmt aus dem Signal S einen die Temperaturabhängigkeit berücksichtigenden Wert des zu messenden Stromes.

Mit einem gemäss dem vorstehenden Ausführungsbeispiel ausgebildeten Sensorkopf 1 wurden in einen zwischen -20°C und 80°C liegenden Temperaturbereich Strommessgenauigkeiten von ca. 0,2% erreicht.

### BEZUGSZEICHENLISTE

- 1: Sensorkopf
- 2: Stromleiter
- 3: Lichtquelle
- 4: Polarisator
- 5: Detektions- und Auswerteeinheit
- 6, 7: HB-Fasern
- 8: Polarimeter
- 9: Wollaston-Prisma
- 10, 11: Photodetektoren
- 12: Vorrichtung zur Ermittlung der Faraday-Rotation
- 13: Vorrichtung zur Stromwert-Bestimmung
- 14: LB-Faser
- 15: Kapillare
- 16: Spulentragkörper
- 17, 18: Klebverbindungen
- 19, 20: Spleissstellen

## Patentansprüche

1. Sensorkopf (1) für eine faseroptische Strommessvorrichtung mit einer verdrillten, um einen Stromleiter (2) geführten und der Leitung von polarisiertem Licht dienenden niedrigdoppelbrechenden Faser (14) zur Detektion der durch das Magnetfeld (H) des zu messenden Stromes (J) hervorgerufenen Rotation des polarisierten Lichtes, dadurch gekennzeichnet, dass die niedrigdoppelbrechende Faser (14) an ihren beiden Enden jeweils mit einer von zwei polarisationserhaltenden, lichtleitenden Fasern (6, 7), von denen eine (6) das polarisierte Licht zuführt, verspleisst und in einer in Form einer Spule gewickelten Kapillare (15) geführt ist, welche aus einem Material gebildet ist, das hinsichtlich seines thermischen Ausdehnungskoeffizienten mit dem Material der niedrigdoppelbrechenden Faser (14) vergleichbar ist, und dass die beiden polarisationserhaltenden Fasern (6, 7) unter Aufnahme der durch die Verdrillung der niedrigdoppelbrechenden Faser (14) hervorgerufenen Torsionskraft jeweils in der Nähe der beiden Spleissstellen (19, 20) befestigt sind.

2. Sensorkopf nach Anspruch 1, dadurch gekennzeichnet, dass die niedrigdoppelbrechende Faser (14) und die Kapillare (15) überwiegend aus Quarz bestehen.

3. Sensorkopf nach Anspruch 1 oder 2, dadurch gekennzeichnet, dass die Kapillare (15) auf einem starren Spulentragkörper (16) elastisch gelagert ist.

4. Sensorkopf nach Anspruch 3, dadurch gekennzeichnet, dass die Kapillare (15) in ein auf dem Spulentragkörper (16) aufliegendes Elastomer eingebettet ist.

5. Sensorkopf nach einem der Ansprüche 1 bis 4, dadurch gekennzeichnet, dass die beiden polarisationserhaltenden Fasern (6, 7) jeweils an entgegengesetzten Enden in die Kapillare (15) eingeführt und im Bereich der jeweiligen Einführöffnung mittels einer Klebverbindung (17, 18) an der Kapillare (15) befestigt sind.

6. Sensorkopf nach Anspruch 5, dadurch gekennzeichnet, dass die Klebverbindung (17, 18) ein Elastomer, wie vorzugsweise Silikon, enthält.

7. Sensorkopf nach einem der Ansprüche 1 bis 6, dadurch gekennzeichnet, dass die das polarisierte Licht zuführende, polarisationserhaltende Faser (6) mit ihrem von der niedrigdoppelbrechenden Faser (14) abgewandten Ende mit einer polarisiertes Licht erzeugenden Faser verspleisst ist.

8. Sensorkopf nach einem der Ansprüche 1 bis 7, dadurch gekennzeichnet, dass die Spleissstellen (19, 20) durch Aufschmelzen gebildet sind.

## Claims

1. Sensor head (1) for a fibre-optic current measuring device with a twisted low-birefringence fibre (14), guided around a current conductor (2) and serving to conduct polarized light, for the detection of that rotation of the polarized light which is caused by the magnetic field (H) of the current (J) to be measured, characterized in that the low-birefringence fibre (14) is spliced at its two ends in each instance with one of two polarization-conserving, light-conducting fibres (6, 7), one (6) of which supplies the polarized light, and is guided in a capillary (15) wound in the shape of a coil, which is formed of a material which is comparable with the material of the low-birefringence fibre (14) with respect to its coefficient of thermal expansion, and in that the two polarization-conserving fibres (6, 7) are secured in each instance in the vicinity of the two splice locations (19, 20) with the absorption of the torsional force generated by the twisting of the low-birefringence fibre (14).

2. Sensor head according to Claim 1, characterized in that the low-birefringence fibre (14) and the capillary (15) predominantly comprise quartz.

3. Sensor head according to Claim 1 or 2, characterized in that the capillary (15) is resiliently mounted on a rigid coil carrier body (16).

4. Sensor head according to Claim 3, characterized in that the capillary (15) is embedded in an elastomer resting on the coil carrier body (16).

5. Sensor head according to one of Claims 1 to 4, characterized in that the two polarization-conserving fibres (6, 7) are inserted in each instance at opposite ends into the capillary (15) and are secured to the capillary (15) in the region of the respective insertion opening by means of an adhesive connection (17, 18).

6. Sensor head according to Claim 5, characterized in that the adhesive connection (17, 18) includes an elastomer such as preferably silicone.

7. Sensor head according to one of Claims 1 to 6, characterized in that the polarization-conserving fibre (6) supplying the polarized light is spliced, by its end remote from the low-birefringence fibre (14), with a fibre generating polarized light.

8. Sensor head according to one of Claims 1 to 7, characterized in that the splice locations (19, 20) are formed by fusion.

## Revendications

1. Tête de sonde (1) pour un dispositif de mesure de courant à fibre optique avec une fibre à faible biréfringence (14) torsadée, conduite autour d'un conducteur électrique (2) et servant à conduire de la lumière polarisée pour la détection de la rotation de la lumière polarisée provoquée par le champ magnétique (H) du courant (J) à mesurer, caractérisée par le fait que la fibre à faible biréfringence (14) est épissée à ses deux extrémités respectivement avec une des deux fibres (6, 7) conductrices de la lumière et conservant la polarisation, dont une (6) amène la lumière polarisée et est conduite dans un tube capillaire (15) enroulé en forme de bobine, qui est constituée d'un matériau qui est comparable au matériau de la fibre à faible biréfringence (14) du point de vue de ses coefficients de dilatation thermique, et par le fait que les deux fibres (6, 7) conservant la polarisation sont respectivement fixées pour la reprise de la force de torsion provoquée par la torsion de la fibre à faible biréfringence (14) à proximité des deux emplacements des épissures (19, 20).

2. Tête de sonde selon la revendication 1, caractérisée en ce que la fibre à faible biréfringence (14) et le tube capillaire (15) sont essentiellement constitués de quartz.

3. Tête de sonde selon la revendication 1 ou 2, caractérisée en ce que le tube capillaire (15) repose de manière élastique sur un support de bobine (16) fixe.

4. Tête de sonde selon la revendication 3, caractérisée en ce que le tube capillaire (15) est noyé dans un élastomère recouvrant le support de bobine (16).

5. Tête de sonde selon l'une des revendications 1 à 4, caractérisée en ce que les deux fibres (6, 7) conservant la polarisation sont insérées respectivement à des extrémités opposées dans le tube capillaire (15) et sont fixées au tube capillaire (15) au voisinage des ouvertures d'introduction correspondantes par une liaison par collage (17, 18).

6. Tête de sonde selon la revendication 5, caractérisée en ce que la liaison par collage (17, 18) contient un élastomère comme de préférence du silicone.

7. Tête de sonde selon l'une des revendications 1 à 6, caractérisée en ce que la fibre (6) conservant la polarisation et amenant la lumière polarisée est épissée par son extrémité opposée à la fibre à faible biréfringence (14) à une fibre produisant de la lumière polarisée.

8. Tête de sonde selon l'une des revendications 1 à 7, caractérisée en ce que les emplacements des épissures (19, 20) sont formés par fusion.
